**Europäisches Patentamt**

**European Patent Office**

**Office européen des brevets**

(19)

(11) Veröffentlichungsnummer: **0 080 652**
**B1**

(12) # EUROPÄISCHE PATENTSCHRIFT

(45) Veröffentlichungstag der Patentschrift:
10.08.88

(51) Int. Cl.⁴: **H 01 L 31/10**

(21) Anmeldenummer: **82110602.8**

(22) Anmeldetag: **16.11.82**

(54) Fototransistor in MOS-Dünnschichttechnik, Verfahren zu seiner Herstellung und Verfahren zu seinem Betrieb.

(30) Priorität: **26.11.81 DE 3146981**

(43) Veröffentlichungstag der Anmeldung:
**08.06.83 Patentblatt 83/23**

(45) Bekanntmachung des Hinweises auf die Patenterteilung:
**10.08.88 Patentblatt 88/32**

(84) Benannte Vertragsstaaten:
**DE FR GB NL**

(56) Entgegenhaltungen:
**DE-A-2 440 325**
**US-A-3 459 944**

**SOLID-STATE ELECTRONICS, Band 15, Nr. 7, 1972, Seiten 789-799, Pergamon Press, Oxford, GB; T.I. KAMINS: "Field-effects in polycrystalline-silicon films"**
**IEEE TRANSACTIONS ON ELECTRON DEVICES, Band ED-27, Nr. 1, Januar 1980, Seiten 293-295, IEEE, New York, US; F. MOHAMMADI u.a.: "A high-voltage MOSFET in polycrystalline silicon"**
**IBM TECHNICAL DISCLOSURE BULLETIN, Band 24, Nr. 7B, Dezember 1981, Seiten 3640-3641, New York, US; S.W. DEPP u.a.: "Method of fabricating FET in polycrystalline silicon"**

(73) Patentinhaber: **Siemens Aktiengesellschaft Berlin und München, Wittelsbacherplatz 2, D-8000 München 2 (DE)**

(72) Erfinder: **Wieder, Armin, Dr., Wiesmahdstrasse 9, D-8035 Gauting (DE)**
Erfinder: **Risch, Lothar, Dr., Gartenstrasse 20b, D-8012 Ottobrunn (DE)**

## Beschreibung

Fototransistors in MOS-Dünnschichttechnik, Verfahren zu seiner Herstellung und Verfahren zu seinem Betrieb.

Die Erfindung betrifft einen Fototransistor in MOS-Dünnschichttechnik, Verfahren zu seiner Herstellung und ein Verfahren zu seinem Betrieb.

Fototransistoren sind hauptsächlich Bipolar-Transistoren, bei denen durch Fotoinjektion von Minoritätsträgern in die Basis der Emitter-Kollektorstrom erhöht wird. Ein großer Nachteil dieser Fototransistoren ist die obere Frequenzgrenze bei einigen kHz. Der Aufbau eines solchen Transistors ist beispielsweise aus dem Band 2, Halbleiterelektronik, R. Müller "Bauelemente der Halbleiterelektronik", 2. Auflage, auf Seite 124 zu entnehmen.

Ein Fototransistor in MOS-Dünnschichttechnik ist aus der DE-A-2 440 325, und aus "Physics of thin films" Vo. 2, G. Hass und R. E. Thun, Academic Press (1964) aus einem Aufsatz von P. K. Weimer "The Insulated-Gate Thin Film Transistor" auf Seite 187 zu entnehmen. Der zuletzt genannte lichtempfindliche Transistor besteht aus fotoleitendem Cadmiumsulfid (CdS) und enthält eine Isolationsschicht aus Siliziummonoxid oder Calziumfluorid, die zusätzlich auf die Cadmiumsulfid-Schicht aufgedampft wird. Zur Erklärung des Fotoeffektes dienen hier tiefe und flache Volumen-Haftstellen. Die flachen Haftstellen unter dem Leitungsband werden durch Licht zusätzlich besetzt und dann durch Feldionisation entleert. Dadurch erhöht sich der Drainstrom durch den Fotostrom. Dieser Transistor leitet bereits im Dunkeln und weist schlechte Transistorseigenschaften auf (verzerrte Kennlinien). Da der Halbleiterkörper aus einer Verbindung besteht und die Isolationsschicht zusätzlich aufgebracht werden muß, ist seine Herstellung schwierig reproduzierbar.

Die Aufgabe, die der Erfindung zugrundeliegt, besteht in der Schaffung eines Fototransistors, der nicht nur leicht herstellbar ist, und platzsparend in einer zweiten Halbleiterebene angeordnet werden kann, sondern auch die Eigenschaft hat, nur bei Belichtung als Funktion der Lichtintensität und der Beitriebsfrequenz seine Leitfähigkeit zu ändern. Außerdem soll der Transistor auch bei hohen Frequenzen ($f_g > 10$ kHz) und kleinen Betriebsspannungen von 5 - 10 V anwendbar sein.

Diese Aufgabe wird durch einen Fototransistor in MOS-Dünnschichttechnik durch die Kennzeichen der Patentansprüche 1 und 2 gelöst.

Das Prinzip, nach dem dieser Transistor arbeitet, läßt sich folgendermaßen erklären:

Durch die Anordnung und die Eigenschaften der Schichten bedingt, hat die Grenzfläche zwischen dem polykristallinen Silizium und dem durch thermische Oxidation erzeugten Oxid eine hohe Defektdichte in der Nähe des Leitungsbandes. Hinzu kommen Defekte im Volumen des polykristallinen Siliziums bzw. Korngrenzen. Diese Defekte bewirken, daß im unbelichteten Zustand bei Anlegen einer Wechselspannung ($\approx 1$ kHz) an das Gate kein Elektronenstrom vom Source nach Drain fließt.

Ohne Belichtung kann das Oberflächenpotential der Gatespannung nur sehr langsam folgen. Es müssen viele Grenzflächendefekte bzw. Korngrenzen umgeladen werden. Dieser Effekt wirkt auf die Transistoreigenschaften wie eine hohe Einsatzspannung und kleine Beweglichkeit. Bei Belichtung werden die Grenzflächen und Volumendefekte nun teilweise gefüllt, und mit steigender Belichtungsintensität sind immer mehr Defekte schon besetzt bzw. die Korngrenzenbarrieren werden abgebaut und das Oberflächenpotential und damit der Drainstrom folgen immer schneller der Gatespannung. Für die Transistoreigenschaften bedeutet dies, die Einsatzspannung sinkt, gleichzeitig erhöht sich die Beweglichkeit der Elektronen. Als Funktion der Gatespannung kann nun ein Elektronenstrom von Source nach Drain fließen. Der Leitwert des Transistors nimmt mit der Lichtintensität zu. Bei hohen Lichtintensitäten können Frequenzen von $> 10$ kHz erreicht werden. Damit liegt hier ein neuartiger Fototransistor-Effekt vor.

Es liegt im Rahmen der Erfindung, daß der polykristalline Siliziumhalbleiterkörper auf ein, als Gateelektrode wirkendes, durch Aufoxidation mit einer $SiO_2$-Schicht versehenes, niederohmiges, einkristallines Siliziumsubstrat oder durch Niederschlagen aus der Dampfphase auf ein isolierendes Substrat erzeugt wird und daß die Source- und Drainzonen in polykristallinem Siliziumhalbleiterkörper mit einer Konzentration von größer $10^{19}$ Arsen $cm^{-3}$ durch maskierte Diffusion oder Ionenimplantation dotiert werden.

Die Erzeugung der Gateoxidschicht durch thermische Oxidation eines polykristallinen Siliziumkörpers ist dabei aus dem Solid State Electronics, Vol. 15, No. 7, 1972, Seiten 789 bis 799 bekannt. In den IEEE Transactions on Electron Devices, Vol. ED-27, No. 1, Jan. 1980, auf den Seiten 293 bis 295, ist ein MOSFET mit einem polykristallinen Silizium-Halbleiterkörper beschrieben, wobei die Gateoxidschicht durch thermische Oxidation der Gate-Elektrode erzeugt wird.

Zur Reduzierung der Dichte der schnellen Oberflächenzustände ist vorgesehen, den Fototransistor nach seiner Fertigstellung mit einer Passivierungsschicht aus einem, Silizium und Wasserstoff enthaltenden Material zu versehen. Durch diese Maßnahme wird erreicht, daß die freien Valenzen an der $Si/SiO_2$-Grenzfläche mit Wasserstoff abgesättigt werden. Als Material eignet sich Siliziumnitrid oder amorphes Silizium, welches durch eine elektrische Niederdruck-Glimmentladung erzeugt ist.

Weitere bevorzugte Ausgestaltungen des erfindungsgemäßen Fototransistors sowie Verfahren zu seiner Herstellung und ein Betriebsverfahren für dieses Bauelement sind in den Unteransprüchen angegeben und werden nachfolgend anhand von in den Figuren dargestellten Ausführungsbeispielen näher erläutert.

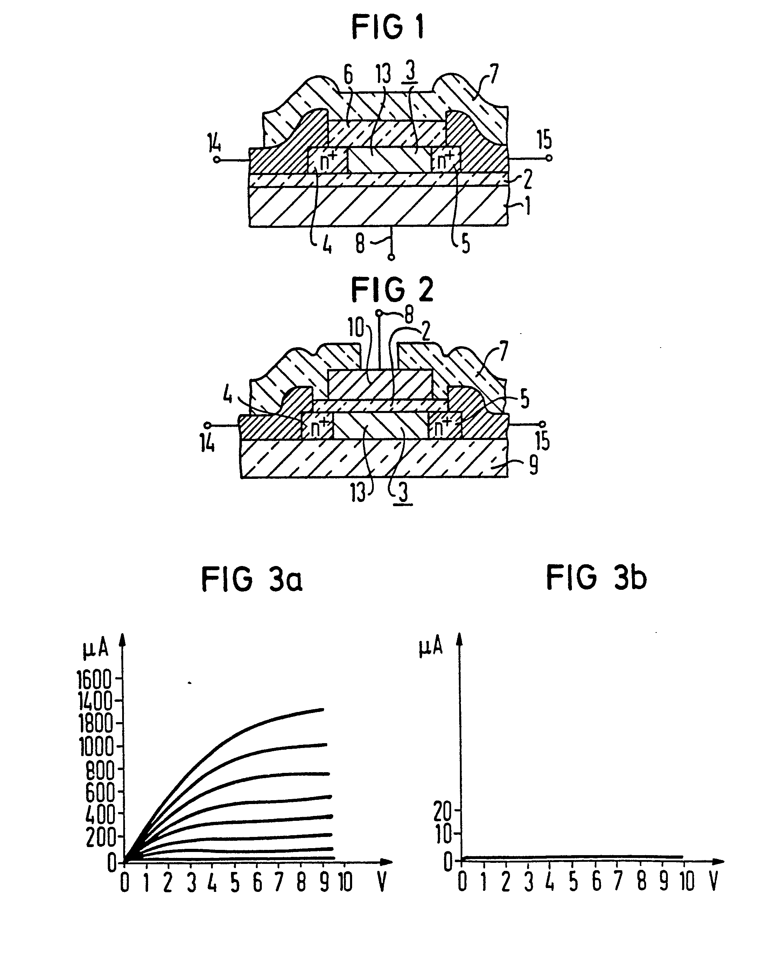

Die Figuren 1 und 2 zeigen schematisch im Schnittbild zwei besondere Ausführungsformen, die Figuren 3a und 3b die Transistorkennlinien (100 - 1000 Hz) ohne Belichtung (3b) und mit Belichtung (3a).

Zur Herstellung eines erfindungsgemäßen Fototransistors wird, wie in Figur 1 gezeigt, auf einem einkristallinen, niederohmigen ($\sim$0,1 Ohm. cm) Siliziumsubstrat 1 durch thermische Oxidation eine $SiO_2$-Schicht 2 von 30 bis 50 nm Dicke erzeugt und darauf bei 625°C durch thermische Zersetzung von Silan ($SiH_4$) eine undotierte polykristalline Siliziumschicht 3 von 500 bis 1000 mm Dicke abgeschieden. Anschließend werden durch maskierte Diffusion oder Ionenimplantation von Arsen-Ionen in einer Konzentration von größer $10^{18}$ cm$^{-3}$ stark n+-dotierte Gebiete 4 und 5, die Source- (4) und Drainzone (5), in der polykristallinen Siliziumschicht 3 hergestellt. Die Anordnung wird dann insbesondere im Bereich des undotierten Kanals 13 der polykristallinen Schicht 3 mit einem Schutzoxid 6 aus $SiO_2$ in einer Schichtdicke von 100 bis 200 nm versehen und mit einer aus Siliziumnitrid oder amorphem Silizium bestehenden Passivierungsschicht 7 in einer Schichtdicke von mindestens 500 nm bedeckt. Dies geschieht mittels einer CVD-Reaktion ( = chemical vapor deposition) in einer elektrischen Niederdruck-Glimmentladung und anschließender Temperung. Abschließend werden noch die Source- (14) und Drainanschlüsse (15) sowie der Gateanschluß 8 an niederohmigen Substrat 1 angebracht.

Bei der in Figur 2 gezeigten Bauart der erfindungsgemäßen Anordnung wird von einem aus amorphem Material bestehenden Substrat 9 (z. B. aus $SiO_2$) ausgegangen, welches, wie bei der Figur 1 beschrieben, mit der undotierten polykristallinen Siliziumschicht 3 aus der Dampfphase versehen wird. Dann werden, ebenfalls wie bereits bei der Figur 1 beschrieben, die Source- und Drainzonen 4 und 5 hergestellt und die Oberfläche des polykristallinen Siliziumkörpers 3 in eine thermisch gewachsene Oxidschicht 2 ($SiO_2$-Schicht, Schichtdicke 30 bis 50 nm) umgewandelt. Nach dem Abscheiden und Strukturieren der aus polykristallinem Silizium bestehenden Gateelektrode 10 wird die der Passivierung dienende, aus Siliziumnitrid oder aus amorphem Silizium bestehende Schicht 7 in einer Schichtdicke von mindestens 500 nm im Glimmentladungsplasma niedergeschlagen und die Anordnung, wie bei Figur 1 beschrieben, nach Entfernen der entsprechenden Bereiche der Passivierungsschicht 7 mit den Source/Drain- (14, 15) und Gateanschlüssen (8) versehen.

Die Figuren 3a und 3b zeigen die Transistorkennlinien ohne Belichtung (Figur 3b) und mit Belichtung (Figur 3a) für einen Transistor mit der Kanalweite w = 100 $\mu$m und der Kanallänge L = 5 $\mu$m. Bei Belichtung (Figur 3a) fällt die Einsatzspannung von $\sim$20 V auf $\sim$2 V ab und die Beweglichkeit steigt von $\sim$0 auf $\sim$10 cm$^2$/Vs.

Wie den Figuren 3a und 3b zu entnehmen ist, folgt der Drainstrom einer Wechselspannung von 1 kHz am Gate. Die Gatespannung ändert sich von 0 V auf + 10 V in Schritten von 1 V. Ohne Belichtung erhöht sich der Drainstrom bei dieser Frequenz nicht.

## Patentansprüche

1. Fototransistor in MOS-Dünnschichttechnik der folgende Merkmale aufweist:
a) ein, als Gateelektrode (1) wirkendes niederohmiges, einkristallines Siliziumsubstrat mit einer darauf befindlichen, durch thermische Oxidation erzeugten $SiO_2$-Schicht (2) und
b) einen, auf dem Substrat (1) angeordneten, durch die $SiO_2$-Schicht (2) getrennten Halbleiterkörper (3) aus polykristallinem Silizium, in dem sich getrennt durch einen undotierten Kanalbereich (13) eine Source- (4) und eine Drainzone (5) befinden (Figur 1).

2. Fototransistor in MOS-Dünnschichttechnik der folgende Merkmale aufweist:
a) einen auf einem isolierenden Substrat (9) angeordneten Halbleiterkörper (3) aus polykristallinem Silizium, in dem sich getrennt durch einen undotierten Kanalbereich (13) eine Source- (4) und eine Drainzone (5) befinden und
b) eine aus polykristallinem Silizium bestehende Gateelektrode (10), die getrennt durch eine, durch Aufoxidation des Halbleiterkörpers (3) gebildete $SiO_2$-Schicht (2) auf dem Halbleiterkörper (3) angeordnet ist (Figur 2).

3. Fototransistor nach Anspruch 1 oder 2, dadurch gekennzeichnet, daß die Dicke des polykristallinen Siliziumhalbleiterkörpers (3) 500 bis 1000 nm beträgt.

4. Fototransistor nach einem der Ansprüche 1 bis 3, dadurch gekennzeichnet, daß der Abstand Source/Drainzone (4, 5) größer 3000 nm beträgt.

5. Fototransistor nach einem der Ansprüche 1 bis 4, dadurch gekennzeichnet, daß die Schichtdicke der durch thermische Oxidation erzeugten $SiO_2$-Schicht (2) 30 bis 50 nm beträgt.

6. Fototransistor nach einem der Ansprüche 1 bis 5, dadurch gekennzeichnet, daß die Source- und Drainzonen (4, 5) mit einer Konzentration von größer $10^{18}$ Arsen cm$^{-3}$ dotiert sind.

7. Fototransistor nach einem der Ansprüche 1 bis 6, gekennzeichnet durch eine Passivierungsschicht (7) aus amorphem Silizium oder Siliziumnitrid mit einer Schichtdicke von mindestens 500 nm.

8. Verfahren zur Herstellung eines Fototransistors in MOS-Dünnschichttechnik nach Anspruch 1, bei dem folgenden Verfahrensschritte nacheinander ausgeführt werden:

a) Erzeugen einer Oxidschicht (2) von 30 bis 50 nm Schichtdicke durch thermische Oxidation eines niederohmigen, einkristallinen Siliziumsubstrats (1),

b) Abscheiden einer undotierten polykristallinen Siliziumschicht (3) auf dem mit der Oxidschicht (2) versehenen Siliziumsubstrat (1) in einer Schichtdicke von 500 bis 1000 nm aus der Dampfphase durch thermische Zersetzung von Silan bei 625°C,

c) Erzeugen von Source- und Drainzonen (4, 5) in der polykristallinen Siliziumschicht (3) durch maskierte Diffusion oder Ionenimplantation von Arsen-Ionen in einer Konzentration von größer $10^{18}$ cm$^{-3}$,

d) Aufbringen einer ganzflächigen, aus SiO$_2$ bestehenden Schutzschicht (6) mit Ausnahme der Bereiche, die für die Kontaktierung der Source/Drainzonen (4, 5) vorgesehen sind,

e) Abscheidung einer aus Siliziumnitrid oder amorphem Silizium bestehenden Passivierungsschicht (7) in einer Schichtdicke von mindestens 500 nm durch elektrische Niederdruck-Glimmentladung,

f) Anbringen der Source- und Drainanschlüsse sowie des Gateanschlusses (8) am niederohmigen Substrat (1) durch Aufdampfen von Metallkontakten.

9. Verfahren zur Herstellung eines Fototransistors in MOS-Dünnschichttechnik nach Anspruch 2, bei dem folgenden Verfahrensschritte nacheinander ausgeführt werden:

a) Abscheiden einer undotierten polykristallinen Siliziumschicht (3) in einer Schichtdicke von 500 bis 1000 nm nach thermischer Zersetzung von Silan bei 625°C auf ein, insbesondere aus amorphem Material bestehendes Substrat (9),

b) Erzeugen von Source- und Drainzonen (4, 5) in der polykristallinen Siliziumschicht (3) durch maskierte Diffusion oder Ionenimplantation von Arsenionen in einer Konzentration von größer $10^{18}$ cm$^{-3}$,

c) Erzeugen einer Oxidschicht (2) von 30 bis 50 nm Schichtdicke durch thermische Oxidation der mit Source- und Drainzonen (4, 5) versehenen polykristallinen Siliziumschicht (3),

d) Abscheidung und Strukturierung einer aus Silizium bestehenden Gateelektrode (10),

e) Abscheidung einer aus Siliziumnitrid oder amorphem Silizium bestehenden Passivierungsschicht (7) in einer Schichtdicke von mindestens 500 nm durch Glimmentladung,

f) Anbringen der Source- und Drainanschlüsse sowie des Gateanschlusses nach Entfernen der entsprechenden Bereiche der Passivierungsschicht (7).

10. Verfahren zum Betrieb eines Fototransistors nach einem der Ansprüche 1 bis 7, dadurch gekennzeichnet, daß an die Gateelektrode Wechselspannungen von 100 Hz bis 1000 Hz mit einem Potential von 0 bis 10 Volt gelegt werden.

## Claims

1. A photo-transistor using MOS thin-film technology which comprises the following features:

a) a low-resistance, monocrystalline silicon substrate serving as gate electrode (1) to which is applied a SiO$_2$-layer (2) produced by thermal oxidation, and

b) a semiconductor body (3) made of polycrystalline silicon which is arranged on the substrate (1) and separated by the SiO$_2$-layer (2) and in which are arranged a source zone (4) and a drain zone (5) separated by an undoped channel zone (13) (Fig. 1).

2. A photo-transistor using MOS thin-film technology which comprises the following features:

a) a semiconductor body (3) made of polycrystalline silicon which is arranged on an insulating substrate (9) and in which are arranged a source zone (4) and a drain zone (5) separated by an undoped channel zone (13), and

b) a gate electrode (10) which consists of polycrystalline silicon and which is arranged on the semiconductor body (3) separated by an SiO$_2$-layer (2) formed by oxidation of the semiconductor body (3) (Fig.2).

3. A photo-transistor as claimed in Claim 1 or 2, characterised in that the thickness of the polycrystalline silicon semiconductor body (3) amounts to 500 to 1000 nm.

4. A photo-transistor as claimed in one of the Claims 1 to 3, characterised in that the distance between the source zone (4) and the drain zone (5) is greater than 3000 nm.

5. A photo-transistor as claimed in one of Claims 1 to 9, characterised in that the layer thickness of the SiO$_2$-layer (2) produced by thermal oxidation, is 30 to 50 nm.

6. A photo-transistor as claimed in one of Claims 1 to 5, characterised in that the source and drain zones (4, 5) are doped with a concentration of more than $10^{18}$ arsenic cm$^{-3}$.

7. A photo-transistor as claimed in one of Claims 1 to 6, characterised by a passivating layer (7) consisting of amorphous silicon or silicon nitride with a layer thickness of at least 500 nm.

8. A process for the production of a photo-transistor using MOS thin-film technology as claimed in Claim 1, in which the following process steps are performed consecutively:

a) formation of an oxide layer (2) of 30 to 50 nm layer thickness by thermal oxidation of a low-resistance, monocrystalline silicon substrate (1),

b) deposition of an undoped polycrystalline silicon layer (3) on the silicon substrate (1), provided with the oxide layer (2), in a layer thickness of 500 to 1000 nm from the vapour phase by thermal decomposition of silane at 625°C,

c) formation of the source and drain zones (4, 5) in the polycrystalline silicon layer (3) by masked diffusion or ion implantation of arsenic ions in a concentration which is greater than $10^{18}$

cm⁻³,

d) application of a SiO2 protective layer (6) to the entire surface, with the exception of those regions provided for the contacting of the source/drain zones (4, 5),

e) deposition of a passivating layer (7), consisting of silicon nitride or amorphous silicon, in a layer thickness of at least 500 nm by low pressure electric glow discharge,

f) application of the source and drain terminals and of the gate terminal (8) to the low-ohmic substrate (1) by the vapour deposition of metal contacts.

9. A process for the production of a photo-transistor using MOS thin-film technology as claimed in Claim 2, in which the following process steps are performed consecutively:

a) deposition of an undoped, polycrystalline silicon layer (3) in a layer thickness of 500 to 1000 nm according to the thermal decomposition of silane at 625°C on to a substrate (9) which consists in particular of amorphous material,

b) formation of source and drain zones (4, 5) in the polycrystalline silicon layer (3) by masked diffusion or ion implantation of arsenic ions in a concentration greater than $10^{18}$ cm⁻³,

c) formation of an oxide layer (2) with a layer thickness of 30 to 50 nm by thermal oxidation of the polycrystalline silicon layer (3) provided with source and drain zones (4, 5),

d) deposition and structuring of a gate electrode (10) consisting of silicon,

e) deposition of a passivating layer (7), consisting of silicon nitride or amorphous silicon, in a layer thickness of at least 500 nm by a glow discharge,

f) application of the source and drain terminals and of the gate terminal following the removal of the appropriate regions of the passivating layer (7).

10. A process for operating a photo-transistor as claimed in one of Claims 1 to 7, characterised in that the gate electrode is connected to alternating voltages of 100 Hz to 1000 Hz with a potential of 0 to 10 volts.


**Revendications**

1. Phototransitor en technologie MOS à couche mince, présentant les caractéristiques suivantes:

a) un substrat en silicium monocristallin, de faible résistance ohmique, agit en tant qu'électrode de grille (1) et porte une couche (2) de SiO2 produite par oxydation thermique et

b) un corps semi-conducteur (3) en silicium polycristallin est disposé sur le substrat (1), en étant séparé de lui par la couche (2) de SiO2, et contient une zone de source (4) et une zone de drain (5) qui sont séparées par une région de canal (13) non dopée (Fig. 1).

2. Phototransistor en technologie MOS à couche mince, présentant les caractéristiques suivantes:

a) un corps semi-conducteur (3) en silicium polycristallin est disposé sur un substrat (9) isolant et contient une zone de source (4) et une zone de drain (5) qui sont séparées par une région de canal (13) non dopée et

b) une électrode de grille (10) en silicium polycristallin est disposée sur le corps semi-conducteur (3), en étant séparée de lui par une couche (2) de SiO2 formée par oxydation de la surface du corps semi-conducteur (3) (Fig. 2).

3. Phototransistor selon la revendication 1 ou 2, caractérisé en ce que l'épaisseur du corps semi-conducteur (3) en silicium polycristallin est de 500 à 1000 nm.

4. Phototransistor selon une des revendications 1 à 3, caractérisé en ce que la distance entre la zone de source et la zone de drain (4, 5) est supérieure à 3000 nm.

5. Phototransistor selon une des revendications 1 à 4, caractérisé en ce que l'épaisseur de la couche (2) de SiO2, formée par oxydation thermique, est de 30 à 50 nm.

6. Phototransistor selon une des revendications 1 à 5, caractérisé en ce que les zones de source et de drain (4, 5) sont dopées avec une concentration superieure à $10^{18}$ d'arsenic cm⁻³.

7. Phototransistor selon une des revendications 1 à 6, caractérisé par une couche de passivation (7) constituée de silicium amorphe ou de nitrure de silicium et ayant une épaisseur d'au moins 500 nm.

8. Procédé pour fabriquer un phototransistor en technologie MOS à couche mince selon la revendication 1, comprenant les opérations suivantes, exécutées successivement:

a) formation d'une couche d'oxyde (2) d'une épaisseur de 30 à 50 nm par oxydation thermique d'un substrat (1) en silicium monocristallin, de faible résistance ohmique,

b) dépôt par décomposition thermique de silane, à 625°C à partir de la phase vapeur, d'une couche non dopée (3) de silicium polycristallin, ayant une épaisseur de 500 à 1000 nm, sur le substrat (1) de silicium, pourvu de la couche d'oxyde (2),

c) formation de zones de source et de drain (4, 5) dans la couche (3) de silicium polycristallin par diffusion ou implantation ionique avec masquage d'ions d'arsenic dans une concentration supérieure à $10^{18}$ cm⁻³,

d) application d'une couche protectrice (6) en SiO2 sur toute la surface, à l'exception des régions prévues pour l'établissement des contacts des zones de source/drain (4, 5),

e) dépôt, par décharge électrique lumineuse sous basse pression, d'une couche de passivation (7) constituée de nitrure de silicium ou de silicium amorphe et ayant une épaisseur d'au moins 500 nm et

f) réalisation des connexions de source et de drain, ainsi que de la connexion de grille (8), sur le substrat (1) de faible résistance ohmique, par évaporation de contacts métalliques.

9. Procédé pour fabriquer un phototransistor en technologie MOS à couche mince selon la revendication 2, comprenant les opérations suivantes, exécutées successivement:

a) dépôt d'une couche de silicium polycristallin (3), d'une épaisseur de 500 à 1000 mn, après décomposition thermique de silane à 625°C, sur un substrat (9) formé en particulier de matériau amorphe,

b) formation de zones de source et de drain (4, 5) dans la couche (3) de silicium polycristallin par diffusion ou implantation ionique avec masquage d'ions d'arsenic dans une concentration supérieure à $10^{18}$ cm$^{-3}$,

c) formation d'une couche d'oxyde (2) d'une épaisseur de 30 à 50 nm par oxydation thermique de la couche (3) de silicium polycristallin, pourvue de zones de source et de drain (4, 5),

d) dépôt et structuration d'une électrode de grille (10) en silicium,

e) dépôt par décharge lumineuse d'une couche de passivation (7) constituée de nitrure de silicium ou de silicium amorphe et ayant une épaisseur d'au moins 500 nm et

f) réalisation des connexions de source et de drain, ainsi que de la connexion de grille, après enlèvement des régions correspondantes de la couche de passivation (7).

10. Procédé pour l'utilisation d'un phototransistor selon une des revendications 1 à 7, caractérisé par l'application à l'électrode de grille de tensions alternatives de 0 à 10 V d'une fréquence de 100 à 1000 Hz.

# FIG 1

# FIG 2

# FIG 3a

# FIG 3b